# EUROPEAN PATENT SPECIFICATION

(11) **EP 3 399 069 B1**
(45) Date of publication and mention of the grant of the patent: **08.12.2021**
(21) Application number: 16881153.7
(22) Date of filing: 26.12.2016
(51) Int. Cl.: C23C 14/26, C23C 14/24

(54) **CRUCIBLE FOR ACCOMMODATING AND HEATING MATERIAL, AND SYSTEM COMPRISING ARRANGED CRUCIBLE AND HEATER**
TIEGEL ZUR AUFNAHME UND ERWÄRMUNG VON MATERIAL UND SYSTEM MIT ANGEORDNETEM TIEGEL UND HEIZELEMENT
CREUSET POUR RECEVOIR ET CHAUFFER UN MATÉRIAU, ET SYSTÈME COMPRENANT UN AGENCEMENT DE CREUSET ET DE CHAUFFAGE

(30) Priority: 31.12.2015 CN 201511026677
(43) Date of publication of application: 07.11.2018
(73) Proprietor: China Triumph International Engineering Co., Ltd., Shanghai 200063 (CN); CTF Solar GmbH, 01099 Dresden (DE); Smit Thermal Solutions B.V., 5692 DH Son (NL)
(72) Inventor: SIEPCHEN, Bastian, 01109 Dresden (DE); KRAFT, Christian, 01109 Dresden (DE); HARR, Michael, 01109 Dresden (DE); PENG,Shou, Shanghai 200063 (CN); KAPER, Gerard, 01109 Dresden (DE); ZIJLMANS, Wiro, 01109 Dresden (DE)
(74) Representative: Kailuweit & Uhlemann Patentanwälte Partnerschaft mbB
(86) International application number: PCT/CN2016/112150
(87) International publication number: WO 2017/114364

(56) References cited:
- WO-A1-2008/016247
- WO-A1-2015/136857
- WO-A1-2015/177217
- CN-A- 101 550 532
- CN-A- 101 550 532
- CN-A- 103 510 051
- CN-U- 203 639 543
- KR-A- 20150 072 828

## Description

### Background of the Present Invention

### Field of Invention

The present invention relates to a crucible for accommodating and heating a material to be vaporized or sublimed, and in particular, to a crucible applicable to accommodating and heating a reactive material, and a system for vaporizing or subliming a material. The system includes the crucible and a heater arrangement for heating the crucible. The crucible and the system are especially applicable to solar cell manufacturing, and a sulphureous or selenium-contained material thereof is vaporized or sublimed.

### Description of Related Arts

A technology used for depositing a material on a substrate is chemical vapor deposition. Steam of the to-be-deposited material is generated from the material source when the material is vaporized or sublimed due to a high temperature (a temperature higher than a temperature making the material boiling or sublimed). Vaporized material granules move toward the substrate and finally deposit on a surface of the substrate. Usually, a crucible for accommodating the to-be-deposited material (that is, the material source) is heated by using a heating lamp, an RF coil, or a resistive heater that is placed on the outside of the crucible or placed at a distance from the crucible. A heater or a heating element is usually thermally separated from the crucible, and heat energy is transferred by radiation or air convection at a large distance. For example, US6,444,043B1 describes a crucible or a container. The crucible or the container is made of one piece of graphite and has a recess or an opening for maintaining the material to be vaporized or sublimed. The crucible is heated by using a heating lamp placed on a sealed side periphery of the crucible and at a distance from the crucible. In US2014/0109829A1, a vaporizing unit includes a crucible and a heater frame which is isolated from the crucible and is set surrounding a lateral surface and a bottom surface of the crucible. A heater for heating the crucible is provided on an inner surface of the heater frame that faces the crucible.

If a space in which the heater is arranged is not sealed, so as to prevent the space from being affected by a space in which vaporized material is scattered, the to-be-deposited material will reach the heater. Consequently, a material with a low heating efficiency may deposit on the surface of the heater, and a material of the heater may be corroded by the to-be-deposited material or a constituent of the to-be-deposited material. For example, the heater may be corroded in a sulphureous atmosphere.

In addition, because the heater is placed at a distance from the crucible, heat transfer is limited by a space and a material in the space between the heater and the crucible.

CN 101 550 532 A describes a heating unit for vacuum thermal evaporation. The corresponding crucible has an inversion at the bottom, called thermal trough, which raises up and in which a heating part of a heater is introduced for heating the material to be evaporated. The heater is arranged at the bottom of the crucible and inside the thermal trough and extends to the sides and, therefore, lies open to the surrounding environment.

WO 2008/016247 A1 describes a linear physical vapor deposition source, wherein a crucible comprising the evaporation material is surrounded by a housing. Heaters are arranged in a space between the housing and the crucible, wherein that space is open at the top surface of the source. A top plate is arranged on the top surface of the source and seals the space between the housing and the crucible.

### Summary of the Present Invention

Therefore, an objective of the present invention is to provide a crucible and a system that comprises the crucible and a heater arrangement. The heater arrangement provides good protection for a heater, to prevent the heater from being affected by surrounding processing atmosphere or possible corrosive processing atmosphere, and provides an improved manner of transferring heat from the heater to the crucible and a simple manner for joining and separating system components.

In order to accomplish the above object, the present invention provides the crucible as in claim 1 and the system, as in claim 6, for vaporizing or subliming a material. Embodiments are comprised in the dependent claims.

The crucible for heating a material to be vaporized or sublimed according to the present invention comprises at least one concave recess, and a bottom recess and a side recess. The concave recess is applicable to accommodating the material to be vaporized or sublimed and is formed on a first surface (also referred to as a top surface) of the crucible. Therefore, the concave recess forms an opening of the crucible on the top surface. The bottom recess is formed on a second surface of the crucible. The second surface is opposite to the first surface and is alternatively referred to as a bottom surface. The bottom recess forms an opening on the bottom surface of the crucible and is applicable to accommodating a bottom heater for heating the bottom surface of the crucible. The side recess is formed in a side wall of the crucible. The side wall extends from the first surface to the second surface and connects the top surface to the bottom surface. The side recess forms a hollow space in the side wall of the crucible and has an opening near the second surface of the crucible. That is, the side recess does not form an opening on a side surface of the crucible, or in other words, the side wall is not open toward a side portion. The side surface is a surface that is of the side wall and that is opposite to a surface of the side wall that is near the concave recess and the bottom recess. In addition, the side surface is one of external surfaces of a body of the crucible. The side recess is applicable to accommodating a side heater that is used for heating the side surface of the crucible.

An external form of the crucible is not limited in any situation, provided that the crucible has a top surface, a bottom surface, and at least one side wall. That is, the crucible may be, for example, a right cylinder or an oblique cylinder that has a circular or oval top surface and/or bottom surface, or a right prism or an oblique prism (for example, a cuboid) of any type, or a form of any type. All recesses are able to extend, to maintain at least a minimum thickness of the material of the crucible at all points, wherein the minimum thickness of the material of the crucible is applicable to ensuring physical stability of the body of the crucible. For example, the minimum thickness of the material of the crucible of a wall that separates the concave recess from the bottom recess or that separates the concave recess from the side recess is in a range from 10 mm to 15 mm relative to graphite used as the material of the crucible and relative to an external size of the body of the crucible that reaches 1.5 m. However, different recesses may have different lengths and/or widths. For example, the concave recess may be smaller than the bottom recess in a lateral size. A size of the concave recess depends on a volume of the material to be vaporized or sublimed and required to be accommodated in the concave recess. A size of the bottom recess and a size of the side recess are selected according to a size of a corresponding heater, and make the corresponding heater completely accommodated (where a connection for providing energy to the heater, if applicable, is excluded) in the corresponding recess. Because the heater (the side heater in particular) is completely accommodated in the corresponding recess of the crucible, the heater is almost completely isolated from a processing atmosphere existing when the material accommodated in the concave recess is vaporized or sublimed. Therefore, the crucible according to the present invention is provided for the heater for excellent protection, to prevent the heater from being affected by a corrosive or reactive constituent of the processing atmosphere. In addition, because the heater may be arranged to be extremely close to the crucible, that is, "in" the body of the crucible, for example, in the side wall of the crucible, therefore, heat transfer from the heater to the material that is to be vaporized or sublimed and accommodated in the concave recess is improved, resulting in a higher achievable temperature or potentially reduced energy required to achieve a specific temperature.

In addition, more than one side recess (for example, two or three or more side recesses) may be formed in a particular side wall, wherein all side recesses have an opening near the second surface of the crucible. Different side recesses in a particular side wall are separated from each other by a material strip formed by the material of the side wall, wherein the material strip forms a middle wall between corresponding side recesses and can extend from the first surface to the second surface of the crucible and through the entire thickness of the side wall. More than one bottom recess may also be formed on the second surface of the crucible, wherein different bottom recesses are separated from each other by a material strip formed by the material of the crucible.

Based on the external form of the crucible, the crucible may have a plurality of side walls. For example, if the crucible is a cuboid, then the crucible has four side walls. In this case, one side recess may be formed in one of the side walls, or more than one side recess may be formed in more than one of the side walls. In other words, each side recess is formed in a particular side wall of the side walls of the crucible. Further, more than one side recess may be formed in a particular side wall, or more than one side wall or even all side walls, as described above. The number of side recesses in a particular side wall may vary as the side wall varies. In an embodiment, a different side recess of the side recesses is formed in all the side walls of the crucible. That is, the number of the side recesses is equal to the number of the side walls of the crucible. Different side recesses may have different sizes in any situation.

In a particular embodiment, the crucible comprises a heat insulation recess, the heat insulation recess is near the side recess and formed on a side wall the same as that of the side recess of the crucible. The heat insulation recess is formed on a side of the side recess that is not near the concave recess of the crucible. The side recess is separated from the heat insulation recess by the material of the crucible. The heat insulation recess is formed with a similar size as that of the side recess, extends from the second surface of the crucible, and has an opening near the second surface of the crucible. The heat insulation recess may be filled with air or any other solid, liquid or gaseous material, if the opening of the heat insulation recess is covered by a cover or any other suitable apparatus, then the heat insulation recess may be evacuated. The heat insulation recess serves as a heat insulation layer or a heat shield that reduces heat transfer to the side surface of the side wall. Therefore, the heat insulation recess further improves heat transfer from the side heater to the material that is to be vaporized or sublimed and accommodated in the concave recess.

Preferably, the crucible is made of a material that has a high heat conductivity and that is noble and non-diffused relative to the material to be vaporized or sublimed or relative to a constituent of an environmental atmosphere (for example, a processing atmosphere existing when the material accommodated in the concave recess is vaporized or sublimed). Therefore, the crucible itself does not react with the material to be vaporized or sublimed or the constituent of the environmental atmosphere. In addition, the crucible reduces or prevents the reactive constituent from passing through a wall of the crucible and being diffused to the heater, so that even if the heater is made of a material that is non-noble relative to the material accommodated in the concave recess or relative to the constituent of the environmental atmosphere, the heater is also prevented from deteriorating or being damaged. Therefore, a material with a low price (for example, stainless steel used for a resistive heater) may be used for the heater. The material of the crucible (for example) is selected from a material group comprising graphite, silicon carbide, and an oxide ceramic material (for example, aluminum oxide).

As described above, the crucible according to the present invention may be applied to a system for vaporizing or subliming a material. The system further comprises a heater arrangement for heating the crucible. The heater arrangement comprises at least one heater arranged in the bottom recess and in the side recess of the crucible. The at least one heater may be a heater of any type, wherein an induction heater or a resistive heater is preferred. If more than one heater (for example, a bottom heater arranged in the bottom recess and a side heater arranged in the side recess) is used, then different heaters may be heaters of different types and sizes. If all heaters are heaters of a same type, then these heaters may be connected to each other or completely separated, so that heat energy provided by a particular heater may be controlled independent of heat energy provided by another particular heater.

If the crucible comprises a plurality of side recesses, then the heater arrangement comprises a plurality of heaters, wherein a particular heater of the heaters is arranged in each of the side recesses. Therefore, heat transfer to the crucible may be well controlled from all sides of the concave recess (except the top surface serving as a vaporization opening). In addition, the temperature of the material accommodated in the concave recess may be highly even.

Because the heater is arranged in the recess of the crucible, the heater (the side heater in particular) is protected by the crucible from being damaged by the reactive constituent of the environmental atmosphere. Therefore, the heater may be made of the material that is non-noble relative to the material to be vaporized or sublimed or relative to the constituent of the environmental atmosphere. In this way, the heater may be used for a relatively long time, and there does not exist deterioration of heat generation or heat transfer caused by damaged heater. In addition, extra gases may be applied to a vaporizing or subliming process without chemically corroding the heater. Therefore, the system of the present invention has the following advantages: a reduced machine downtime caused by necessary replacement of the heater (where this is true even a reactive or corrosive constituent is used during processing); highly efficient heat transfer and economical energy use; and simple and compact setting of the system.

To further protect the heater, the heater may be coated with a material that has a high heat conductivity and that is noble and non-diffused relative to the material to be vaporized or sublimed or relative to a constituent of an environmental atmosphere.

When the system is mounted or arranged in a processing chamber to make the crucible arranged on a mounting panel in the chamber or on a chamber wall of the processing chamber, the opening of the bottom recess and/or the opening of the side recess are covered and sealed respectively, to prevent them from being affected by an atmosphere (for example, the processing atmosphere) that is outside of the recess. Certainly, providing energy to the heater arranged in the corresponding recess should be ensured by using, for example, an opening that is in the mounting panel or chamber wall and through which a connection line of the heater may pass, or by using an interface that provides connection between the heater in the recess and the outside world and that is arranged in the mounting panel or chamber wall. The term "seal" does not necessarily mean "airtight", but mean that a corrosive constituent is apparently less diffused to the recess. With reference to the crucible and the structure described above of the system that comprises the crucible and the at least one heater, degrading of the heater caused by the corrosive environmental atmosphere can be significantly reduced, while providing a simple structural setting and assembling for the system.

However, one or more or all of the bottom recess and/or the side recess of the crucible may be covered or sealed by using one or more shield covers or covers. That is, the bottom recess and all side recesses may be sealed by a particular shield cover, thereby being protected from the impact of the environmental atmosphere. Alternatively, only the bottom recess is sealed. Alternatively, only one side recess or more recesses selected from the bottom recess and the side recess are sealed, instead of sealing all recesses. The shield cover or cover may be mounted on the crucible or the system or other components of the processing chamber, and may be made of any suitable material (for example, the material of the crucible).As described above with respect to the mounting panel or the chamber wall, providing energy to the heater arranged in the corresponding recess should be ensured by using, for example, an opening that is in the corresponding shield cover and through which a connection line of the heater may pass, or by using an interface that provides connection between the heater in the recess and the outside world and that is arranged in the corresponding shield cover. Such a shield cover may be particularly applicable to the following situation: The mounting panel or any other mounting system has an opening, so that the bottom recess and/or the side recess is not sealed by the mounting panel or the mounting system.

### Brief Description of the Drawings

The accompanying drawings are comprised in the specification, to provide further understanding of embodiments of the present invention, and are integrated into the specification of the present invention and form a part of the specification of the present invention. The accompanying drawings describe the embodiments of the present invention and are used for explaining the principle together with the specification of the present invention. Other embodiments and many expected merits of the present invention can be easily learned, for the embodiments and expected merits can be better understood with reference to the following detailed descriptions. Elements in the accompanying drawings are not necessarily scaled by proportion relative to each other. Similar reference signs represent similar parts.
Fig. 1 is a perspective view of an exemplary embodiment of a crucible according to the present invention.
Fig. 2 is a top view of the crucible in Fig. 1.
Fig. 3 is a bottom view of the crucible in Fig. 1.
Fig. 4 is a bottom view of another embodiment of the crucible.
Fig. 5 is a cross-sectional view of the crucible in Fig. 1 along a line A-A' in Fig. 3.
Fig. 6 is an exemplary embodiment of a heater arrangement that is a part of a system for vaporizing or subliming a material according to the present invention.
Fig. 7 is a cross-sectional view of a processing chamber that is used for vaporizing or subliming of an exemplary embodiment of a system for vaporizing or subliming a material according to the present invention.

### Detailed Description of the Preferred Embodiments

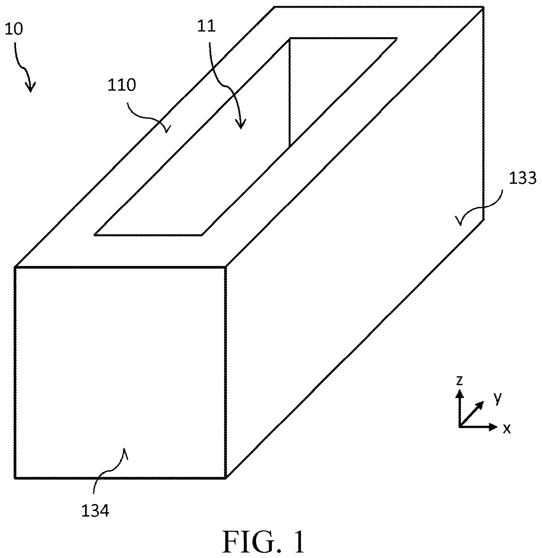

Fig. 1 shows an exemplary embodiment of a crucible 10 according to the present invention. The crucible 10 is a cuboid that is made of graphite or any other suitable material and having six surfaces: a first surface 110 that is a top surface, a second surface that is a bottom surface (not visible in the figure), and four side surfaces. In the figure, only side surfaces 133 and 134 are visible. A concave recess 11 is formed on the first surface 110, and the concave recess 11 is applicable to accommodating a material to be vaporized or sublimed. The concave recess 11 has an opening on the first surface and may have any suitable form and size. In addition, the crucible 10 may have more than one concave recesses 11. For example, the crucible may have a plurality of concave recesses, wherein each concave recess is formed as a cylindrical hole on the first surface, and different concave recesses are separated from each other by a material of the crucible.

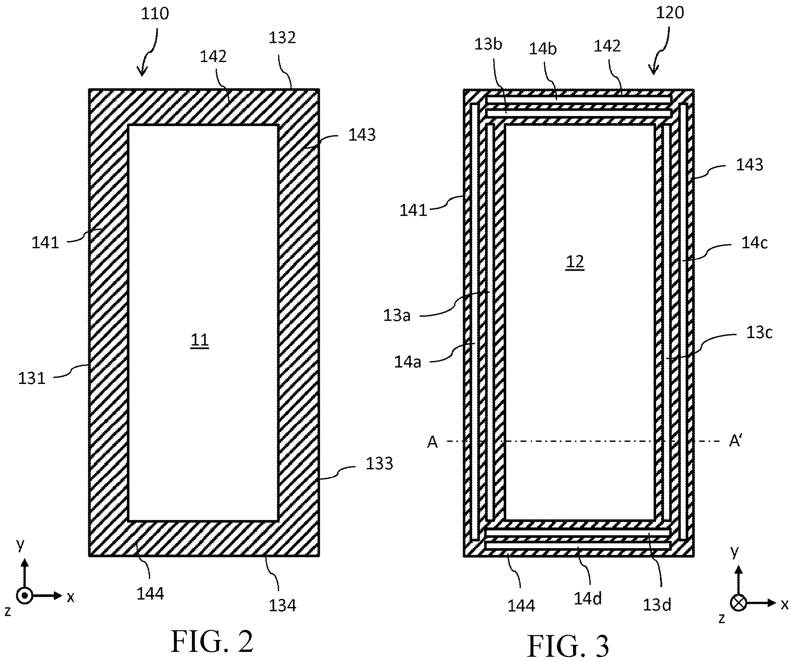

Fig. 2 is a top view of the crucible 10, in which the first surface 110 is shown. The concave recess 11 is formed on the first surface 110. The material of the crucible 10 forms side walls 141 to 144 of the crucible 10, and the side walls 141 to 144 extend from the concave recess 11 to the corresponding side surfaces 131 to 134 of the crucible. The side walls 141 to 144 extend from the first surface 110 to the second surface, that is, extend in the z direction, and connect a top and a bottom of the crucible 10.

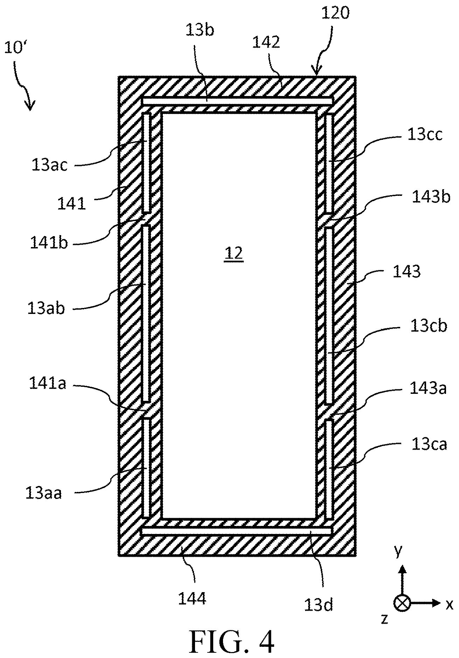

Fig. 3 is a bottom view of the crucible 10, in which the second surface 120 opposite to the first surface 110 is shown. A bottom recess 12 is formed on the second surface 120. The bottom recess 12 is used for accommodating a bottom heater in a process in which the crucible is used for vaporizing or subliming. The bottom recess 12 may have any suitable form and size. In addition, openings of side recesses 13a to 13d can be seen from Fig. 3. Each of the side recesses 13a to 13d is formed in a corresponding side wall of the side walls 141 to 144 and extends in the z direction, as will be explained in the following description of Fig. 4. Lateral sizes of the openings of the side recesses 13a to 13d on the second surface 120 and lateral sizes of the side recesses 13a to 13d are as small as possible (where all lateral sizes are measured in the x direction or they direction), provided that a side heater can be inserted into each of the side recesses 13a to 13d without being damaged and that the side heater is allowed to be thermally expanded in the side recesses 13a to 13d during heating. In addition, in the side walls141 to 144, heat insulation recesses 14a to 14d are formed on sides of the corresponding side recesses 13a to 13d away from the concave recess and facing the corresponding side surfaces. The heat insulation recesses 14a to 14d are surrounded by materials of the corresponding side walls 141 to 144 and have openings near the second surface 120. Preferably, the heat insulation recesses 14a and 14c have similar sizes in the y direction as those of the corresponding side recesses 13a and 13c or have sizes even greater than those of the corresponding side recesses 13a and 13c.

Fig. 4 is a bottom view of another crucible 10'. The difference between the crucible 10' and the crucible 10 is only that three side recesses 13aa to 13ac and three side recesses 13ca to 13cc are respectively formed in each of the side walls 141 and 143 of the crucible. In addition, to make the figure clearer, the heat insulation recess shown in Fig. 3 is not shown in Fig. 4. Each of the side recesses 13aa to 13ac is separated from a neighboring side recess of the side recesses 13aa to 13ac respectively by using material strips 141a and 141b. The material strips 141a and 141b are a part of the side wall 141, and form middle walls between corresponding side recesses of the side recesses 13aa to 13ac. The material strips 141a and 141b extend from the first surface 110 to the second surface 120. The material strips 141a to 141b increase the stability of the side wall 141, and make it possible to insert different side heaters into the corresponding side recesses 13aa to 13ac. In this way, different lateral areas of the crucible 10' near the side wall 141 can be heated independently to further increase the uniformity of the temperature of the material accommodated in the concave recess. The described features of the side recesses 13aa to 13ac and the side wall 141 are also applicable to the side recesses 13ca to 13cc and the side wall 143.

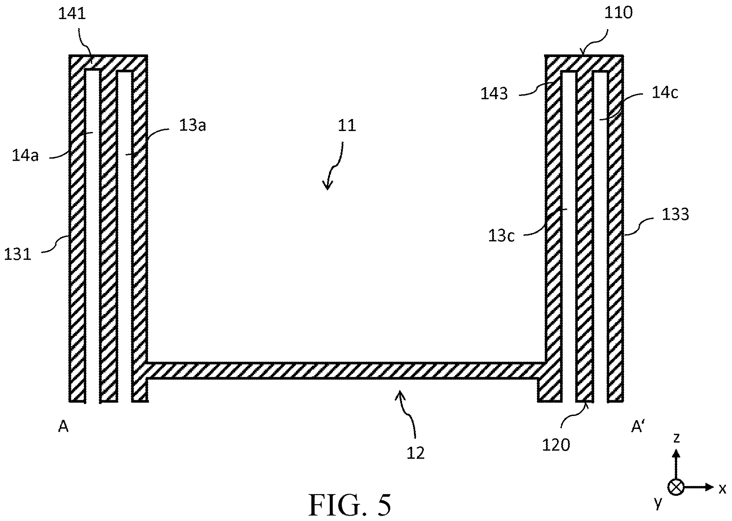

Fig. 5 is a cross-sectional view through the crucible 10 along a line A-A' in Fig. 3. In the cross-sectional view, the concave recess 11 on the first surface 110, the bottom recess 12 on the second surface 120, and the two side recesses 13a and 13c on the side walls 141 and 143 can be seen. The side recesses 13a and 13c extend along the z direction, almost over the entire size of the crucible 10, and have their openings near the second surface 120. In addition, in each of the side walls 141 and 143, the heat insulation recesses 14a and 14c are formed on sides of the corresponding side recesses 13a and 13c away from the concave recess 11 and facing the corresponding side surfaces 131 and 133. Each of the heat insulation recesses 14a and 14c has an opening near the second surface 120. For example, the heat insulation recesses 14a and 14c may be filled with air. Sizes of the heat insulation recesses 14a and 14c in the x direction are limited only by a general external size of the crucible 10 and stability of the crucible itself. In the z direction towards the first surface 110, the heat insulation recesses 14a and 14c preferably extend to a distance the same as or even longer than a distance to which the corresponding side recesses 13a and 13c extend.

Table 1 shows exemplary sizes of the crucible 10 and different elements of the crucible 10. As is clearly understood, the crucible 10' may have a similar size, and the side recesses 13aa to 13ac and the side recesses 13ca to 13cc are relatively small in the y direction.

**Table 1**

| | Size (mm) | | |
|---|---|---|---|
| | In the xdirection | In the y direction | In the z direction |
| Crucible 10 | 277 | 1294 | 287 |
| Concave recess 11 | 177 | 1210 | 243 |
| Bottom recess 12 | 200 | 1210 | 15 |
| Side recesses 13a and 13c | 16 | 1194 | 217 |
| Side recesses 13b and 13d | 205 | 18 | 252 |
| Heat insulationrecesses14a and 14c | 10 | 1194 | 217 |
| The minimum thickness of a material of a side wall between two elements (for example, between the concave recess 11 and the side recess 13a) | 10 to 15mm | | |

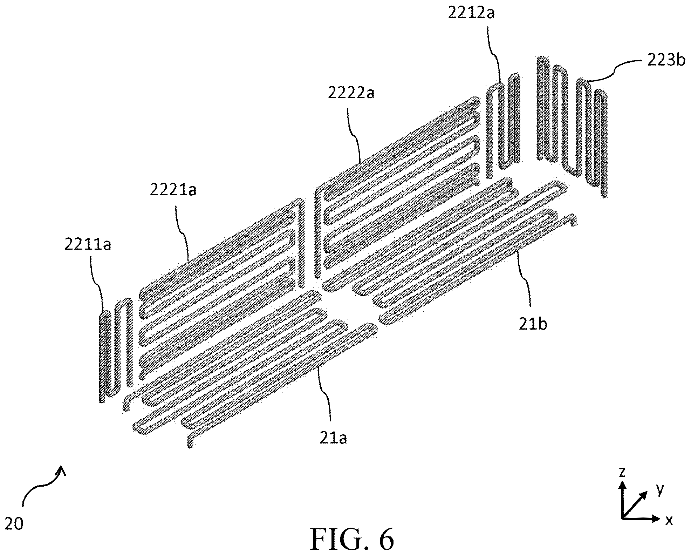

Fig. 6 shows an exemplary heater arrangement 20 for heating the crucible 10 in Fig. 1 to Fig. 3. The heater arrangement 20 comprises two bottom heaters 21a and 21b, two corner heaters and two middle heaters for each long side of the crucible, and a side heater for each short side of the crucible. In Fig. 6, for clarity, only a side heater 223b for a short side of the crucible, corner heaters 2211a and 2212a and middle heaters 2221a and 2222a for a long side of the crucible, and two bottom heaters 21a and 21b are shown. Each of the heaters 2211a, 2212a, 2221a, and 2222a that are used for the long side of the crucible may be inserted into a same side recess in a corresponding side wall or may be inserted into different side recesses formed in a corresponding side wall. The heater is a resistive heater formed as a conductive loop. A material of a wire of the heater is molybdenum, but may further be any other suitable material.

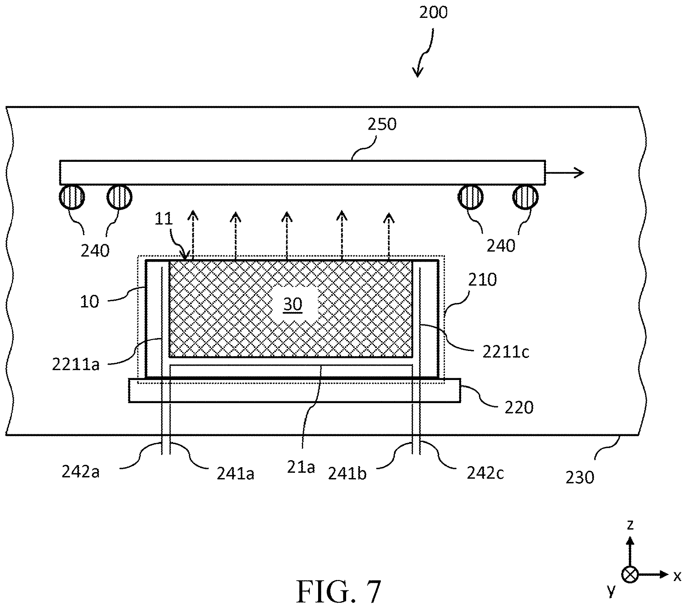

Fig. 7 is a cross-sectional view through a processing chamber 200 that is used for vaporizing or subliming. In the processing chamber 200, a system 210 for vaporizing or subliming a material according to the present invention is arranged on a mounting panel 220 or directly mounted on a chamber wall 230. The system 210 comprises the crucible 10 and the heater arrangement 20 as described above. A concave recess 11 accommodates a material 30 to be vaporized or sublimed and the material 30 to be vaporized or sublimed is heated by the heater of the heater arrangement described above. As described in Fig. 5, the heater is arranged in a bottom recess and a side recess. However, in Fig. 7, for clarity, the bottom recess and the side recess are not shown. In addition, the heat insulation recess described in Fig. 5 is also not shown in Fig. 7 for the same reason. In the cross-sectional view of Fig. 7, only the bottom heater 21a and two corner heaters 2211a and 2211c are shown. However, more heaters may be provided in the heater arrangement as described above in Fig. 6. In addition, Fig. 7 shows energy supply connections 241a and 241b for supplying energy to the bottom heater 21a and energy supply connections 242a and 242c for supplying energy to the corner heaters 2211a and 2211c respectively. The energy supply connections 241a, 241b, 242a and 242b are guided to the outside of the processing chamber 200, and the energy supply connections 241a, 241b, 242a and 242b are connected to one or more generators. Due to heat generated by the heater of the heater arrangement, the material 30 is vaporized or sublimed and moves toward a substrate 250, as indicated by the dashed arrow. The substrate 250 is held and moves above the system 210 with assistance of a transfer roller 260. The substrate 250 (the substrate 250 may alternatively be a plurality of substrates arranged in a substrate holder) moves within the processing chamber 200 in the direction indicated by the solid arrow. However, static deposition of the material 30 (that is, the deposition of a material on the substrate 250 that does not move) may also be possible.

As is clearly known by those skilled in the art, the heater of the heater arrangement is fixed relative to the crucible 10 and the processing chamber 200 anyhow. This case is also suitable for the crucible 10 itself. That is, the heater of the heater arrangement may be fixed in a corresponding recess (the bottom recess and/or the side recess), or may be fixed on the mounting panel 220 or the chamber wall 230 or one or more shield covers. The one or more shield covers are mounted to the bottom surface of the crucible 10 and seal a corresponding recess. Therefore, even if the recess is not sealed by any component of the system, the heater may not drop out of the recess of the crucible. In order to arrange the heater of the heater arrangement in the corresponding recess of the crucible 10, the heater may be inserted into a recess for fixing the crucible, or the crucible 10 may slide from the top of a fixed heater. However, the two components (the crucible and the heater) are movable, so that the heater is inserted into the corresponding recess of the crucible.

Because the heater of the heater arrangement is arranged in the crucible 10, heat transfer from the heater to the material 30 is optimized. In addition, the recess of the crucible 10 where the heater is arranged is sealed by the mounting panel 220, so that the heater is effectively prevented from being affected by an environmental atmosphere in the chamber 200. The environmental atmosphere may comprise a constituent that is corrosive relative to a material of the heater. In addition, the crucible 10 may be separated from the heater by simply lifting the crucible 10 to make the crucible 10 away from the mounting panel 220. Therefore, if a first crucible 10 must be cleaned or another material 30 must be vaporized or sublimed, then the first crucible 10 may be replaced with a second crucible 10 without detaching the heater arrangement.

## Claims

1. A crucible (10) for heating a material (30) to be vaporized or sublimed, comprising
at least one concave recess (11), the concave recess (11) is applicable to accommodating a material (30) to be vaporized or sublimed, and the concave recess (11) is formed on a first surface (110) of the crucible (10); and
a bottom recess (12) and a side recess (13a-13d), the bottom recess (12) is formed on a second surface (120) of the crucible (10), the second surface (120) is opposite to the first surface (110), and the side recess (13a-13d) is formed in a side wall (141-144) of the crucible (10), the side wall (141-144) extends from the first surface (110) to the second surface (120), wherein the side recess (13a-13d) has an opening near the second surface (120) of the crucible (10).

2. The crucible as in claim 1, wherein the crucible (10) comprises a plurality of side recesses (13a-13d) so that a particular side recess (13a-13d) of the side recesses (13a-13d) is formed in each of all side walls (141-144) of the crucible (10).

3. The crucible as in claim 1 or 2, wherein the crucible (10) further comprises a heat insulation recess (14a ― 14d), the heat insulation recess (14a ― 14d) is formed within the same side wall (141-144) of the side recess (13a-13d) of the crucible (10) and is formed on a side of the side recess (13a-13d) that is not near the concave recess (11) of the crucible (10) and that is near the side recess (13a-13d), wherein the side recess (13a-13d) is separated from the heat insulation recess (14a, 14c) by a material of the crucible (10).

4. The crucible as in any of the foregoing claims, wherein the crucible (10) is made of a material that has a high heat conductivity and that is noble and non-diffused relative to the material (30) to be vaporized or sublimed or relative to a constituent of an environmental atmosphere.

5. The crucible as in claim 4, wherein the material of the crucible (10) is selected from a material group comprising graphite, silicon carbide, and an oxide ceramic material.

6. A system for vaporizing or subliming a material (30), comprising the crucible (10) as in any of the foregoing claims and a heater arrangement (20) for heating the crucible (10), wherein the heater arrangement (20) comprises at least one heater arranged in the bottom recess (12) and in the side recess (13a-13d) of the crucible (10).

7. The system as in claim 6, wherein the crucible (10) comprises a plurality of side recesses (13a-13d) and the heater arrangement (20) comprises a plurality of heaters, wherein a particular heater of the heaters is arranged in each of the side recesses (13a-13d).

8. The system as in claim 6 or 7, wherein the at least one heater is made of a material that is non-noble relative to the material (30) to be vaporized or relative to a constituent of an environmental atmosphere.

9. The system as in claim 8, wherein the at least one heater is coated with a material that has a high heat conductivity and that is noble and non-diffused relative to the material (30) to be vaporized or sublimed or relative to a constituent of an environmental atmosphere.

10. The system as in any one of claims 6 to 9, wherein the system further comprises at least one shield cover, and the at least one shield cover is used for sealing at least one of the bottom recess (12) or the side recess (13a-13d) of the crucible (10) to prevent the bottom recess (12) or the side recess (13a-13d) from being affected by an environmental atmosphere.

## Patentansprüche

1. Tiegel (10) zum Erhitzen eines zu verdampfenden oder zu sublimierenden Materials (30), umfassend
- mindestens eine konkave Aussparung (11), die geeignet ist, um das zu verdampfende oder zu sublimierende Material (30) aufzunehmen, wobei die konkave Aussparung (11) in einer ersten Oberfläche (110) des Tiegels (10) gebildet ist, und
- eine untere Aussparung (12) und eine seitliche Aussparung (13a-13d), wobei die untere Aussparung (12) in einer zweiten Oberfläche (120) des Tiegels (10) gebildet ist, wobei die zweite Oberfläche (120) der ersten Oberfläche (110) gegenüberliegt, und die seitliche Aussparung (13a-13d) in einer Seitenwand (141-144) des Tiegels (10) gebildet ist, wobei sich die Seitenwand (141-144) von der ersten Oberfläche (110) zur zweiten Oberfläche (120) erstreckt, wobei die seitlichen Aussparung (13a-13d) eine Öffnung nahe der zweiten Oberfläche (120) des Tiegels (10) hat.

2. Tiegel nach Anspruch 1, wobei der Tiegel (10) mehrere seitliche Aussparungen (13a-13d) umfasst, so dass in jeder von allen Seitenwänden (141-144) des Tiegels (10) eine jeweilige seitliche Aussparung (13a-13d) der seitlichen Aussparrungen (13a-13d) gebildet ist.

3. Tiegel nach Anspruch 1 oder 2, wobei der Tiegel (10) ferner eine wärmeisolierende Aussparung (14a-14d) umfasst, die innerhalb derselben Seitenwand (141-144) der seitlichen Aussparung (13a-13d) des Tiegels (10) und auf einer Seite der seitlichen Aussparung (13a-13d) gebildet ist, welche nicht zur konkaven Aussparung (11) des Tiegels (10), jedoch zu der seitlichen Aussparung (13a-13d) benachbart ist, wobei die seitliche Aussparung (13a-13d) von der wärmeisolierenden Aussparung (14a, 14c) durch das Material des Tiegels (10) beabstandet ist.

4. Tiegel nach einem der vorherigen Ansprüche, wobei der Tiegel (10) aus einem Material besteht, das eine hohe Wärmeleitfähigkeit hat und inert und diffusionsdicht bezüglich des zu verdampfenden oder zu sublimierenden Materials (30) oder bezüglich eines Bestandteils einer Umgebungsatmosphäre ist.

5. Tiegel nach Anspruch 4, wobei das Material des Tiegels (10) aus der Gruppe umfassend Grafit, Siliziumkarbid und Oxidkeramikmaterial ausgewählt ist.

6. System zum Verdampfen oder Sublimieren eines Materials (30) umfassend einen Tiegel (10) nach einem der vorherigen Ansprüche und eine Heizkörperanordnung (20) zum Erhitzen des Tiegels (10), wobei die Heizkörperanordnung (20) mindestens einen Heizkörper, der in der unteren Aussparung (12) und in der seitlichen Aussparung (13a-13d) des Tiegels (10) angeordnet ist, umfasst.

7. System nach Anspruch 6, wobei der Tiegel (10) mehrere seitliche Aussparungen (13a-13d) umfasst und die Heizkörperanordnung (20) mehrere Heizkörper umfasst, wobei in jeder der seitlichen Aussparungen (13a-13d) ein spezifischer Heizkörper der Heizkörper angeordnet ist.

8. System nach Anspruch 6 oder 7, wobei mindestens ein Heizkörper aus einem Material besteht, welches bezüglich des zu verdampfenden oder zu sublimierenden Materials (30) oder bezüglich eines Bestandteils einer Umgebungsatmosphäre nicht inert ist.

9. System nach Anspruch 8, wobei mindestens ein Heizkörper mit einem Material beschichtet ist, das eine hohe Wärmeleitfähigkeit hat und inert und diffusionsdicht bezüglich des zu verdampfenden oder zu sublimierenden Materials (30) oder bezüglich eines Bestandteils einer Umgebungsatmosphäre ist.

10. System nach einem der Ansprüche 6 bis 9, wobei das System ferner mindestens eine Abdeckung umfasst, die zum Abdichten mindestens einer der unteren Aussparung (12) oder der seitlichen Aussparung (13a-13d) des Tiegels (10) genutzt wird, um eine Beeinflussung der unteren Aussparung (12) oder der seitlichen Aussparung (13a-13d) durch eine Umgebungsatmosphäre zu vermeiden.

## Revendications

1. Creuset (10) pour chauffer un matériau (30) à vaporiser ou sublimer, comprenant
au moins un évidement concave (11), l'évidement concave (11) étant applicable pour recevoir un matériau (30) à vaporiser ou sublimer, et l'évidement concave (11) étant formé sur une première surface (110) du creuset (10) ; et
un évidement inférieur (12) et un évidement latéral (13a-13d), l'évidement inférieur (12) étant formé sur une seconde surface (120) du creuset (10), la seconde surface (120) étant opposée à la première surface (110) et l'évidement latéral (13a-13d) étant formé dans une paroi latérale (141-144) du creuset (10), la paroi latérale (141-144) s'étendant de la première surface (110) à la seconde surface (120), l'évidement latéral (13a-13d) ayant une ouverture proche de la seconde surface (120) du creuset (10).

2. Creuset selon la revendication 1, dans lequel le creuset (10) comprend une pluralité d'évidements latéraux (13a-13d) de telle sorte qu'un évidement latéral (13a-13d) particulier des évidements latéraux (13a-13d) est formé dans chacune de toutes les parois latérales (141-144) du creuset (10).

3. Creuset selon la revendication 1 ou 2, dans lequel le creuset (10) comprend en outre un évidement d'isolation thermique (14a - 14d), l'évidement d'isolation thermique (14a - 14d) étant formé à l'intérieur de la même paroi latérale (141-144) de l'évidement latéral (13a-13d) du creuset (10) et étant formé sur un côté de l'évidement latéral (13a-13d) qui n'est pas proche de l'évidement concave (11) du creuset (10) et qui est proche du côté évidement (13a-13d), l'évidement latéral (13a-13d) étant séparé de l'évidement d'isolation thermique (14a, 14c) par un matériau du creuset (10).

4. Creuset selon l'une quelconque des revendications précédentes, dans lequel le creuset (10) est fait d'un matériau qui a une conductivité thermique élevée et qui est noble et non diffusé par rapport au matériau (30) à vaporiser ou sublimer ou par rapport à un constituant d'une atmosphère ambiante.

5. Creuset selon la revendication 4, dans lequel le matériau du creuset (10) est choisi parmi un groupe de matériaux comprenant du graphite, du carbure de silicium et un matériau céramique d'oxyde.

6. Système pour vaporiser ou sublimer un matériau (30), comprenant le creuset (10) selon l'une quelconque des revendications précédentes et un agencement de chauffage (20) pour chauffer le creuset (10), dans lequel l'agencement de chauffage (20) comprend au moins un élément de chauffage agencé dans l'évidement inférieur (12) et dans l'évidement latéral (13a-13d) du creuset (10).

7. Système selon la revendication 6, dans lequel le creuset (10) comprend une pluralité d'évidements latéraux (13a-13d) et l'agencement de chauffage (20) comprend une pluralité d'éléments de chauffage, dans lequel un élément de chauffage particulier des éléments de chauffage est agencé dans chacun des évidements latéraux (13a-13d).

8. Système selon la revendication 6 ou 7, dans lequel l'au moins un élément de chauffage est constitué d'un matériau qui n'est pas noble par rapport au matériau (30) à vaporiser ou par rapport à un constituant d'une atmosphère ambiante.

9. Système selon la revendication 8, dans lequel l'au moins un élément de chauffage est revêtu d'un matériau qui a une conductivité thermique élevée et qui est noble et non diffusé par rapport au matériau (30) à vaporiser ou sublimer ou par rapport à un constituant d'une atmosphère ambiante.

10. Système selon l'une quelconque des revendications 6 à 9, dans lequel le système comprend en outre au moins un couvercle de protection, et l'au moins un couvercle de protection est utilisé pour fermer hermétiquement l'évidement inférieur (12) et/ou l'évidement latéral (13a -13d) du creuset (10) pour éviter que l'évidement inférieur (12) ou l'évidement latéral (13a-13d) ne soit affecté par une atmosphère ambiante.
